# EUROPÄISCHE PATENTSCHRIFT

(11) **EP 3 449 508 B1**
(45) Veröffentlichungstag und Bekanntmachung des Hinweises auf die Patenterteilung: **01.07.2020**
(21) Anmeldenummer: 18700149.0
(22) Anmeldetag: 10.01.2018
(51) Int. Cl.: H01L 31/02, H01L 31/112, H01Q 1/22, H01Q 9/28, H01Q 23/00, H01L 29/04

(54) **STRAHLUNGSDETEKTOR UND VERFAHREN ZU DESSEN HERSTELLUNG**
RADIATION DETECTOR AND METHOD FOR PRODUCING SAME
DÉTECTEUR DE RAYONNEMENT ET SON PROCÉDÉ DE PRODUCTION

(30) Priorität: 23.02.2017 DE 102017103687
(43) Veröffentlichungstag der Anmeldung: 06.03.2019
(73) Patentinhaber: Forschungsverbund Berlin E.V., 12489 Berlin (DE)
(72) Erfinder: RÄMER, Adam, 12051 Berlin (DE); SHEVCHENKO, Sergey, 12489 Berlin (DE)
(74) Vertreter: Gulde & Partner
(86) Internationale Anmeldenummer: PCT/EP2018/050501
(87) Internationale Veröffentlichungsnummer: WO 2018/153557

(56) Entgegenhaltungen:
- BAUER MARIS ET AL: "High-sensitivity wideband THz detectors based on GaN HEMTs with integrated bow-tie antennas", 2015 10TH EUROPEAN MICROWAVE INTEGRATED CIRCUITS CONFERENCE (EUMIC), EUMA, 7. September 2015 (2015-09-07), Seiten 1-4, XP032823222, DOI: 10.1109/EUMIC.2015.7345053 [gefunden am 2015-12-02]
- M. SAKOWICZ ET AL: "Mechanism of Radiation Coupling to Plasma Wave Field Effect Transistor Sub-THz Detectors", ACTA PHYSICA POLONICA: SERIES A, Bd. 114, Nr. 5, 1. November 2008 (2008-11-01), Seiten 1337-1342, XP055460789, PL ISSN: 0587-4246, DOI: 10.12693/APhysPolA.114.1337
- MIRIAM S. VITIELLO ET AL: "Room-Temperature Terahertz Detectors Based on Semiconductor Nanowire Field-Effect Transistors", NANO LETTERS, Bd. 12, Nr. 1, 11. Januar 2012 (2012-01-11), Seiten 96-101, XP055033014, ISSN: 1530-6984, DOI: 10.1021/nl2030486
- TANIGAWA T ET AL: "AlGaN/GaN plasmon-resonant terahertz detectors with on-chip patch antennas", LASERS AND ELECTRO-OPTICS, 2009 AND 2009 CONFERENCE ON QUANTUM ELECTRONICS AND LASER SCIENCE CONFERENCE. CLEO/QELS 2009. CONFERENCE ON, IEEE, PISCATAWAY, NJ, USA, 2. Juni 2009 (2009-06-02), Seiten 1-2, XP031521741, ISBN: 978-1-55752-869-8

## Beschreibung

Die vorliegende Erfindung betrifft einen Strahlungsdetektor und ein Verfahren zu dessen Herstellung. Insbesondere betrifft die vorliegende Erfindung einen Strahlungsdetektor zur Detektion von THz-Strahlung basierend auf einem Feldeffekttransistor (FET) mit einer an die FET-Struktur monolithisch integrierten Antennenstruktur und ein Verfahren zur Herstellung einer solchen monolithisch integrierten Detektoranordnung.

### Stand der Technik

Unter dem Begriff "Terahertz-Frequenzbereich" versteht man grob den Frequenzbereich von etwa 100 GHz bis 30 THz. Dieser Bereich umspannt die Freiraumwellenlängen von λ = 3 mm bis λ = 10 µm, weswegen er auch Submillimeterwellenlängenbereich genannt wird. In diesem Bereich ist die Energie der Photonen gering, sie liegt zwischen 0,1 meV und 100 meV.

Dieser Bereich des elektromagnetischen Spektrums wird auch als THz-Lücke bezeichnet, da der Bereich für kommerzielle Anwendungen bisher kaum erschlossen ist. Dieses rührt u.a. daher, dass bei rein elektronischen Systemen die erzeugten Signale in der Größenordnung des Rauschens liegen. Für rein photonische Ansätze ist die Energie der Photonen jedoch zu gering.

In den letzten Jahrzehnten wurden immer wieder hochkomplexe Systeme entwickelt, die im Submillimeterwellenlängenbereich arbeiten. Das Einsatzgebiet dieser Systeme ist bisher aber ausschließlich der experimentelle Bereich in Forschung und Entwicklung, wie z.B. in der Radioastronomie, der Atmosphärenforschung oder der Langzeitspektroskopie von Gasen. Für den Durchbruch in den kommerziellen Massenmarkt sind diese Systeme nicht geeignet. Das liegt vor allem an der fehlenden Verfügbarkeit von kostengünstigen Quellen und Detektoren für den THz-Bereich und an deren Betrieb zumeist bei Temperaturen unterhalb von 77 K.

Es besteht ein großes Interesse den THz-Frequenzbereich zu erschließen, da er gegenüber anderen Frequenzbereichen einige Vorteile und Einzigartigkeit aufweist. THz-Strahlung ist nicht ionisierend und wird daher im biomedizinischen Bereich als sicher angesehen. Mit THz-Strahlung können Informationen über die Ladungsträgerdynamik in Nanostrukturen gewonnen werden. Viele Materialien, die im optischen Frequenzbereich undurchsichtig sind, sind im THz-Frequenzbereich transparent. Bestimmte Molekülgruppen zeigen einen eindeutigen spektralen Fingerabdruck im THz-Frequenzbereich. Dieser Fingerabdruck ist gerade für die Detektion von Gefahrenstoffen von Interesse. Weiterhin zeigt THz-Strahlung eine geringere Streuung verglichen mit optischen Frequenzen und ist dadurch gerade für die Verwendung in staubiger Umgebung geeignet. Für die Anwendung in Kommunikationssystemen spricht die zu erzielende hohe Übertragungsbandbreite. Die geringe Wellenlänge von THz-Strahlung ermöglicht hohe Strukturauflösungen bei radargestützten Verfahren sowie der Be- bzw. Durchleuchtung von Proben, was beispielsweise für In-situ-Messungen in Produktionsprozessen zur Qualitätskontrolle von besonderem Interesse ist.

Zur Detektion von THz-Strahlung im unteren THz-Frequenzbereich (bis ca. 1 THz) eignen sich rein elektrische Systeme basierend auf GaAs-, SiGe-, CMOS- und InP-Halbleitertechnologien, meist mit Vervielfacher-Konzepten. Weiterhin können zur Detektion von THz-Strahlung Schottky-Diodenmischer und photokonduktive Detektoren verwendet werden. Als Leistungsdetektoren kommen photovoltaische Detektoren, Golay-Zellen und Bolometer zum Einsatz. Zur Erzeugung von THz-Strahlung oberhalb weniger THz werden zumeist Quantenkaskadenlasersysteme, optoelektronische Systeme basierend auf Femtosekunden-Kurzpulslaser oder die Mischung zweier Dauerstrichlaser genutzt.

In den letzten Jahren wurde gezeigt, dass sich auch Transistoren aus dem Hochfrequenzbereich (1-80 GHz) für die Detektion von THz-Strahlung eignen (T. Otsuji and M. Shur, "Terahertz Plasmonics: Good Results and Great Expectations," in IEEE Microwave Magazine, vol. 15, no. 7, pp. 43-50, Nov.-Dec. 2014). Insbesondere zwei Mechanismen führen dazu, dass solche Transistoren im THz-Spektrum eingesetzt werden können. Dabei handelt es sich zum einen um eine resistive Mischung im aktiven Gebiet des Transistors und zum anderen um plasmonische Effekte im aktiven Gebiet des Transistors, welche durch die Dyakonov-Shur-Theorie (M. Dyakonov and M. Shur, "Detection, mixing, and frequency multiplication of terahertz radiation by two-dimensional electronic fluid," IEEE Trans. Electron Devices, vol. 43, no. 3, pp. 380-387, Mar. 1996) beschrieben werden können.

Für diese Art der Detektion von THz-Strahlung eignen sich vorrangig Feldeffekttransistoren (FETs) in CMOS- (M. Bauer et al., "Real-time CMOS terahertz camera employing plane-to-plane imaging with a focal-plane array of field-effect transistors," 2013 38th International Conference on Infrared, Millimeter, and Terahertz Waves (IRMMW-THz), Mainz, 2013, pp. 1-2) und GaN-Halbleitertechnologie (M. Bauer et al., "High-sensitivity wideband THz detectors based on GaN HEMTs with integrated bowtie antennas," Microwave Integrated Circuits Conference (EuMIC), 2015 10th European, Paris, 2015, pp. 1-4).

Um die THz-Strahlung erfassen und empfangen zu können, werden verschiedene Antennentypen verwendet. Insbesondere kommen hierbei Bowtie-Antennen, Spiralantennen und Patchantennen zum Einsatz.

In DE 10 2007 062 562 B4 und DE 10 2011 076 840 B4 wird gezeigt, dass es bei THz-Frequenzen notwendig ist, die Antenne und den Transistor auf dem gleichen Substrat integriert aufzubauen. Der Transistor und die Antenne sind dabei durch elektrische Zuleitungen miteinander verbunden, wodurch Leitungsverluste auftreten und die Antenne an den Transistor angepasst werden muss. Dadurch arbeiten die Detektoren schmalbandig und erzielen nur eine suboptimale Performance.

### Offenbarung der Erfindung

Es ist daher eine Aufgabe der vorliegenden Erfindung, eine monolithisch integrierbare Struktur zur Erfassung der Leistung und/oder der Phase elektromagnetischer Strahlung im THz-Frequenzbereich anzugeben. Weiterhin soll sich eine solche Strahlungsdetektor-Anordnung dadurch auszeichnen, dass sie eine abgeschlossene, definierte THz-Umgebung bereitstellt, in der sich monolithisch eingebettet ein Frequenzumsetzer befindet, welcher die THz-Strahlung in einen niedrigen Frequenzbereich bis hinab zu Gleichstrom umsetzt. Durch eine monolithisch integrierbare Struktur soll insbesondere auf elektrische Zuleitungen verzichtet werden können, so dass Leitungsverluste vermindert werden und die Antenne in Bezug auf die fehlenden Zuleitungen nicht an den Transistor angepasst werden muss. Dadurch sollen eine große Bandbreite mit hoher Empfindlichkeit, gepaart mit einer hohen Integrationsdichte ermöglicht werden.

Diese Aufgaben werden erfindungsgemäß durch die Merkmale des Patentanspruchs 1 sowie des Patentanspruchs 13 gelöst. Zweckmäßige Ausgestaltungen der Erfindung sind in den jeweiligen Unteransprüchen enthalten.

Ein erfindungsgemäßer Strahlungsdetektor umfasst eine Antennenstruktur und eine Feldeffekttransistor-Struktur (FET-Struktur) mit einem Source-Bereich, einem Gate-Bereich, und einem Drain-Bereich, wobei diese Bereiche auf einem Substrat angeordnet sind und durch Metallisierung voneinander unabhängige elektrisch leitfähige Elektrodenstrukturen ausbilden, wobei die Gate-Elektrodenstruktur die Source-Elektrodenstruktur oder die Drain-Elektrodenstruktur in einer ersten Ebene vollständig umschließt; sich die umschlossene Elektrodenstruktur bis oberhalb der Gate-Elektrodenstruktur erstreckt und dort die Umschließung in einer zweiten Ebene oberhalb der ersten Ebene zumindest abschnittsweise flächig überdeckt; wobei zwischen den von der umschlossenen Elektrodenstruktur überdeckten Bereichen der Gate-Elektrodenstruktur ein elektrisch isolierender Bereich zur Ausbildung eines Kondensators mit einer Metall-Isolator-Metall-Struktur (MIM-Struktur) angeordnet ist.

Als Strahlungsdetektor werden im Allgemeinen technische Anordnungen bezeichnet, welche dazu ausgebildet sind, elektromagnetische Strahlung zu empfangen und ein entsprechendes, zu Eigenschaften der empfangenen Strahlung in Beziehung stehendes, Detektionssignal auszugeben.

Die Antenne einer Detektionseinrichtung für elektromagnetische Strahlung hat im Allgemeinen die Aufgabe, auf die Antenne auftreffende elektromagnetische Freiraumwellen zu empfangen und in geführte Leiterwellen zu überführen. Dazu weist eine Antenne i.d.R. mehrere Empfangselemente auf (z.B. die beiden Arme einer klassischen Dipolantenne). Ein Abgreifen der empfangenen Leiterwelle kann im sogenannten Antennenfußpunkt (auch als zentraler Speisepunkt bezeichnet) erfolgen. Der Begriff "Antennenstruktur" berücksichtigt dabei die äußere Geometrie der Gesamtheit aller Empfangselemente, deren gegenseitige Anordnung sowie deren intrinsischen Aufbau (z.B. mehrlagiger Schichtaufbau) vom äußeren Rand der Antenne bis zum Antennenfußpunkt.

Die elektrische Ansteuerung der unterschiedlichen Bereiche eines FET erfolgt typischerweise über drei voneinander unabhängige metallische Elektroden, wobei der Begriff "FET-Struktur" den intrinsischen Aufbau des FET mit den elementaren Elektrodenstrukturen, d.h. ohne eine Antennenstruktur, erfasst. Die Elektroden werden dabei zumeist durch Abscheidung oder Auftragung von Metallen oder metallhaltigen Verbindungen oberhalb der einzelnen Bereiche des FET (d.h. oberhalb der FET-Struktur) angeordnet.

Der Begriff "Elektrodenstruktur" berücksichtigt dabei sowohl die äußere Geometrie der Elektroden als auch deren intrinsischen Aufbau (z.B. Aufbau der Elektrode aus verschiedenen Schichten oder Elektrodenelementen). Elektrisch unmittelbar miteinander verbundene Bereiche können dabei eine zusammenhängende Elektrodenstruktur ausbilden. Vorzugsweise kann die Source-Elektrodenstruktur einen ohmschen Source-Kontakt und eine Source-Metallisierung umfassen. Vorzugsweise kann die Drain-Elektrodenstruktur einen ohmschen Drain-Kontakt und eine Drain-Metallisierung umfassen. Die Gate-Elektrodenstruktur kann unterschiedliche Metallisierungsebenen und eine Gate-Metallisierung umfassen. Bevorzugt wird die Gate-Elektrodenstruktur vollständig von einer Gate-Metallisierung ausgebildet. Eine Metallisierung kann dabei insbesondere durch das Aufbringen von reinen Metallen, Verbindungsmetallen oder sonstigen elektrisch leitfähigen metallischen Verbindungen erfolgen.

Ein Kondensator besteht im Allgemeinen aus zwei gegeneinander elektrisch isolierten Flächenelementen (z.B. beim Plattenkondensator) auf denen elektrische Ladungen gespeichert werden können. Diese Flächen werden auch als Kondensatorelektroden bezeichnet. Als Metall-Isolator-Metall-Struktur (MIM-Struktur) werden im Bereich der Halbleitertechnik vor allem flächig ausgebildete kapazitive metallische Schichtstapel mit einer zwischenliegenden Isolationsschicht (elektrisch isolierender Bereich) bezeichnet. Dabei kann es sich bei der Isolationsschicht beispielsweise um ein Siliziumoxid, Silizium-Nitrid oder ein sonstiges elektrisch isolierendes Material oder Medium handeln. Erfindungsgemäß wird zwischen den von der umschlossenen Elektrodenstruktur überdeckten Bereichen der Gate-Elektrodenstruktur ein elektrisch isolierender Bereich zur Ausbildung eines Kondensators mit einer MIM-Struktur angeordnet.

Vorzugsweise ist die Antennenstruktur auf dem Substrat aufliegend unmittelbar von Elektrodenstrukturen ausgebildet. Dies bedeutet, dass die Antennenstruktur eine im Wesentlichen planare Antennenausführung darstellt, wobei die Elektrodenstrukturen des FET selbst als Empfangselemente der Antennenstruktur ausgebildet sein können. Vorzugsweise ist zwischen der Antennenstruktur und dem Substrat eine Epitaxiestruktur angeordnet. Die Antennenstruktur kann jedoch zumindest abschnittsweise auch unmittelbar auf dem Substrat aufliegend ausgebildet sein.

Besonders bevorzugt wird die Antennenstruktur unmittelbar von der Source-Elektrodenstruktur und der Drain-Elektrodenstruktur ausgebildet. Vorzugsweise wird der MIM-Kondensator von zumindest einem Teil der Gate-Elektrodenstruktur durch einen sich zumindest mit einem Teil der Source-Elektrodenstruktur oder zumindest einem Teil der Drain-Elektrodenstruktur überdeckenden Bereich ausgebildet. Die Antennenstruktur kann jedoch zumindest abschnittsweise auch über die Gate-Elektrodenstruktur ausgebildet sein.

Die Idee der vorliegenden Erfindung besteht somit darin, die Antennenstruktur in unmittelbare Nähe zum Transistor anzuordnen, wobei auf elektrische Zuleitungen und den mit ihnen verbunden Nachteilen vollständig verzichtet werden kann. Insbesondere kann die Antennenstruktur zur maximalen Abstandsminimierung auch unmittelbar aus den entsprechenden Elektrodenstrukturen des Transistors ausgebildet sein. Durch die ebenfalls mögliche Integration eines Kondensators in die Antennen- bzw. FET-Struktur kann eine gemeinsame HF-Umgebung ausgebildet werden, die dazu eingerichtet werden kann, den Strahlungsdetektor auf den Empfang von elektromagnetischen Wellen im THz-Bereich abzustimmen. Dadurch, dass die Gate-Elektrodenstruktur die Source-Elektrodenstruktur oder die Drain-Elektrodenstruktur in einer ersten Ebene vollständig umschließt, lässt sich ein breitbandigerer Kurzschluss als bei einseitigen Elektrodenstrukturausführungen realisieren. Durch eine besonders kurze Umschließungsstrecke erfolgt bei hohen Frequenzen keine Transformation des Kurzschlusses zu hohen Impedanzwerten. Weiterhin führt ein Umschließen zu einer besonders hohen RF-Entkopplung der Drain- und Source-Bereiche. Insbesondere stellt der Gate-Bereich dabei das RF-Bezugspotenzial der Anordnung dar. Da die zum Gate-Bereich fließenden hochfrequenten Ströme vorwiegend ringförmig an den Kanten der Umschließung auftreten (Skin-Effekt) wird zudem das Fernfeld der Antenne auch bei hohen Frequenzen nicht wesentlich durch den Stromfluss in der Umschließung gestört.

Da ein solcher erfindungsgemäßer Strahlungsdetektor sowohl Empfangselement als auch Detektorelement ist, ermöglicht dieses Konzept eine große Bandbreite mit hoher Empfindlichkeit, gepaart mit einer hohen Integrationsdichte. Da die Struktur in einem Standard-Halbleiterprozess gefertigt werden kann, ist sie zudem relativ leicht herstellbar und kostengünstig. Dadurch ermöglicht das zugrundeliegende Konzept den Aufbau der Strukturen für Anwendungen für den Massenmarkt im Bereich THz-Strahlung. Die Grundlage eines erfindungsgemäßen Strahlungsdetektors bildet daher ein Feldeffekttransistor (FET) mit seinen drei Elektroden Source, Gate und Drain, wobei die Elektroden so geformt werden können, dass sie eine genau definierte HF-Umgebung erzeugen.

Vorzugsweise haben der ohmsche Source-Kontakt und der ohmsche Drain-Kontakt eine Höhe zwischen 0,1 µm und 0,5 µm. Bevorzugter ist eine Höhe von etwa 0,25 µm. Eine bevorzugte Länge des ohmschen Source-Kontaktes liegt bei größer als 3 µm. Bevorzugter ist eine Länge zwischen 4 µm und 6 µm. Vorzugsweise haben der ohmsche Source-Kontakt und der ohmsche Drain-Kontakt eine Breite größer als 1 µm. Bevorzugter ist eine Breite zwischen 3 µm und 4 µm.

In einigen Ausführungsformen kann im Bereich der FET-Struktur 20 die Breite des ohmschen Source-Kontaktes 34a und des ohmschen Drain-Kontaktes 38a voneinander abweichen. Vorzugsweise hat der ohmsche Source-Kontakt eine Breite von etwa 4 µm und der ohmsche Drain-Kontakt eine Breite etwa 1 µm. Weiterhin bevorzugt sind Ausführungsformen bei denen der ohmsche Source-Kontakt eine Breite von etwa 10 µm und der ohmsche Drain-Kontakt eine Breite von etwa 1 µm aufweisen. Bevorzugter sind bei solchen asymmetrischen Ausführungsformen Asymmetrie-Verhältnisse (Breite des ohmschen Source-Kontaktes zur Breite des ohmschen Drain-Kontaktes) von zwischen 1:2 und 1:10, bevorzugter zwischen 1:4 und 1:10, noch bevorzugter zwischen 1:6 und 1:10.

Vorzugsweise hat die Gate-Elektrodenstruktur eine Höhe zwischen 0,3 µm und 0,5 µm. Bevorzugter ist eine Höhe von etwa 0,35 µm. Vorzugsweise hat die Source-Metallisierung im Bereich des Kondensators eine Höhe zwischen 0,5 µm und 1,2 µm. Bevorzugter ist eine Höhe von etwa 0,65 µm. Vorzugsweise haben die Source-Metallisierung und die Drain-Metallisierung im Bereich des Kondensators eine Breite größer als 3 µm. Bevorzugter ist eine Breite zwischen 4 µm und 6 µm.

Vorzugsweise hat der elektrisch isolierende Bereich eine Höhe zwischen 0,01 µm und 0,5 µm. Bevorzugter ist eine Höhe von etwa 0,2 µm.

Vorzugsweise überdecken sich die Gate-Elektrodenstruktur in der ersten Ebene und die umschließende Elektrodenstruktur in der zweiten Ebene im Wesentlichen als rechteckige Flächenelemente. Die den MIM-Kondensator ausbildende Überdeckung, wobei mit Überdeckung der sich bei einer senkrechten Projektion der einander zugewandten Oberflächen der Gate-Elektrodenstruktur und der umschließenden Elektrodenstruktur ergebende gemeinsame Flächenbereich gemeint ist, kann dabei in Analogie zu den beiden (parallel zueinander angeordneten) Kondensatorelektroden eines klassischen Plattenkondensators angesehen werden. Der Ausdruck "im Wesentlichen" bezieht sich dabei auf eine allgemein rechteckige Form der sich überdeckenden Flächenelemente. Die einzelnen Elektrodenstrukturen an sich können in ihrer Formung davon abweichen.

Vorzugsweise ist die FET-Struktur auf der Basis von Silizium oder einem III-V-Halbleiter aufgebaut. Entsprechend ist es bevorzugt, dass die FET-Struktur in Sibasierter Technologie ausgeführt ist (z.B. CMOS). Weiterhin ist es bevorzugt, dass die FET-Struktur in III-V-Technologie ausgeführt ist. Besonders bevorzugte Technologien zum Aufbau der FET-Struktur bzw. eines erfindungsgemäßen Strahlungsdetektors können auf GaN, Graphen oder auf Hochtemperatur-Supraleitern (auch als HTC-Superkonduktoren bezeichnet) basieren. Vorzugsweise bildet das zum Aufbau der genannten Strukturen verwendete Substrat keine Massefläche gegenüber dem Antennenelement aus. Insbesondere hochresistives Silizium kann hierbei als Substratmaterial eingesetzt werden.

Vorzugsweise ist der Fußpunkt der Antennenstruktur zwischen dem Gate-Bereich und dem Source-Bereich oder zwischen dem Gate-Bereich und dem Drain-Bereich angeordnet ist. Bevorzugter ist, dass der Fußpunkt der Antennenstruktur zwischen dem Gate-Bereich und dem Source- bzw. Drain-Bereich der nicht umschlossenen Elektrodenstruktur angeordnet ist. Insbesondere kann der Fußpunkt der Antennenstruktur genau mittig zwischen diesen beiden Bereichen angeordnet sein. Dadurch kann erreicht werden, dass eine von der Antennenstruktur empfangene elektromagnetische Welle (z.B. eine Freiraumwelle) unmittelbar am Antennenfußpunkt in den FET eingekoppelt werden kann. Auf zusätzliche Leiterstrecken, in denen empfangene Strahlungswellen im Stand der Technik als Leitungswellen in Antennenzuleitungen geführt werden müssten, kann somit verzichtet werden. Eine Detektion der von der Antennenstruktur empfangenen Strahlung kann daher ohne zusätzliche Leitungsverluste unmittelbar am Fußpunkt der Antennenstruktur erfolgen.

Vorzugsweise bildet die Antennenstruktur eine Schlitzantenne aus, wobei die Antennenstruktur mindestens eine strahlende Öffnung innerhalb einer Metallfläche aufweist (solche Antennenstrukturen werden unabhängig von der spezifischen Formgebung der strahlenden Öffnung ganz allgemein als Schlitz- oder Slot-Antenne bezeichnet). Bei Schlitzantennen handelt es sich um Antennen, bei denen das strahlende Element der Antenne im Wesentlichen durch eine Öffnung (allgemein als strahlende Öffnung bezeichnet) in einer leitenden Ebene ausgebildet wird. Einer solchen strahlenden Öffnung kann entsprechend dem babinetschen Theorem im Fernfeld die Abstrahl- bzw. Empfangscharakteristik eines klassischen Dipols zugeordnet werden (komplementärer Dipol mit gleicher Intensitätsverteilung). Die durch ein anregendes elektromagnetisches Feld induzierten Ströme fließen dabei im Wesentlichen entlang des metallischen Randes der Öffnung. Unter dem Ausdruck "strahlende Öffnung" ist somit insbesondere eine Öffnung innerhalb einer zugeordneten Antennenstruktur zu verstehen, die für diese Antennenstruktur gemäß dem babinetschen Theorem einen komplementären Dipol als empfangendes Element darstellt. Eine Einkopplung von zu empfangenden elektromagnetischen Signalen in die Antennenstruktur kann dabei vorzugsweise über das Substrat erfolgen.

Bei der Metallfläche kann es sich um eine einzelne metallische Fläche oder eine aus Einzelelementen bestehende, zusammengesetzte metallische Fläche handeln. Die Einzelelemente können dabei galvanisch voneinander getrennt sein, wobei die Trennung durch zusätzliche MIM-Kondensatoren zwischen Einzelelementen ausbildet sein kann. Vorzugsweise führen MIM-Kondensatoren zwischen Einzelelementen zu einer galvanischen Trennung, bei der eine HF-mäßige Verbindung zwischen den jeweils über einen MIM-Kondensator getrennten Einzelelementen erhalten bleibt. Insbesondere ist bevorzugt, dass als empfangendes Element der Antenne eine strahlende Öffnung in den Metallisierungen der Elektrodenstrukturen verwendet wird und die Gesamtstruktur von einer hochfrequenzmäßig verbundenen Masse umschlossen ist. Dabei ist es besonders bevorzugt, dass auf dem äußeren Rand der Antennenstruktur Hochfrequenz-Ströme (HF-Ströme) mit Frequenzen größer als 100 GHz kurzgeschlossenen sind. Dadurch können die Strukturen einerseits als Array angeordnet werden, ohne ihre Nachbarn zu stören. Andererseits können dadurch auch die HF-Signale auf den (nach außen führenden) Anschlussleitungen des Strahlungsdetektors unterdrückt werden. Bei einer Schlitzantenne ergibt sich durch das Invertieren von Luft und Metall ein größerer Gestaltungsspielraum für die Realisierung des Kurzschlusses und bei der Ausgestaltung der unterschiedlichen Elektrodenanordnungen.

Insbesondere ist bevorzugt, dass die Antennenstruktur einen HF-Kurzschluss zwischen 2 der 3 Bereiche der FET-Struktur realisiert. Dabei werden besonders bevorzugt die Gate- und Source-Elektrodenstrukturen (bzw. die Gate- und Drain-Elektrodenstrukturen) in einer, in Bezug zu den räumlichen Abmessungen der FET-Struktur, großen Fläche als MIM-Struktur übereinander angeordnet, um einen möglichst idealen HF-Kurzschluss zwischen dem intrinsischen Gate- und Source-Bereichen (bzw. den Gate- und Drain-Bereichen) zu realisieren. Vorzugsweise übersteigt die von der MIM-Struktur auf dem Substrat überdeckte Fläche die vom 2DEG der FET-Struktur auf dem Substrat überdeckte Fläche um den Faktor 100, bevorzugter um den Faktor 1.000, noch bevorzugter um den Faktor 10.000.

Besonders bevorzugte Ausführungsformen einer Antennenstruktur sind resonante Hole-Antennen,

Teardrop-Antennen, Schlitz-Patch-Antennen, Schlitz-Bowtie-Antennen sowie Schlitzlog-Spiral-Antennen. Eine Antennenstruktur kann dabei vorzugsweise 2-armig oder 4-armig ausgebildet sein. Bei einer 4-armig ausgebildeten Antennenstruktur können insbesondere zwei voneinander unabhängige FET-Strukturen eine gemeinsame Antennenstruktur als Empfangselement nutzen oder ein erfindungsgemäßer Strahlungsdetektor umfasst zwei parallel geschaltete FET-Strukturen auf einem gemeinsamen Substrat, wobei in beiden Fällen jede FET-Struktur mit je 2 Armen der 4-armig ausgebildeten Antennenstruktur verbunden ist. Allgemein kann bei mehrarmigen Antennenstrukturen eine Vielzahl von einzelnen oder parallel geschalteten FET-Strukturen zum Einsatz kommen. Weiterhin können gemischte Formen vorliegen, bei dem bei einer mehrarmigen Antennenstruktur einzelne Arme individuellen FET Strukturen zugeordnete sind und andere Arme zu parallel geschalteten FET Strukturen führen.

Vorzugsweise bilden der Kondensator und die Antennenstruktur eine gemeinsame HF-Umgebung aus, dazu eingerichtet, den Strahlungsdetektor auf den Empfang von elektromagnetischen Wellen im THz-Bereich abzustimmen. Insbesondere können über eine entsprechende Dimensionierung der Antennenstruktur und durch eine Einstellung der Kapazität des Kondensators die Empfangseigenschaften (Empfindlichkeit, spektrale Bandbreite, Signalverstärkung) eines erfindungsgemäßen Strahlungsdetektors abgestimmt bzw. eingestellt werden. Dadurch kann im Rahmen der vorliegenden Offenbarung ein erfindungsgemäßer Strahlungsdetektor auf eine Vielzahl von Anwendungsfällen hin optimiert werden. Diese Anwendungen sind jedoch nicht auf den Bereich der THz-Strahlung eingeschränkt.

Vorzugsweise umfasst ein erfindungsgemäßer Strahlungsdetektor weiterhin einen Frequenzumsetzer, wobei der Frequenzumsetzer die empfangene Strahlung in ein niederfrequentes Detektionssignal umsetzt. Die Auswertung des erfindungsgemäßen Strahlungsdetektors erfolgt dabei vorzugsweise durch eine niederfrequente Auswertung der Ströme bzw. Spannungen zwischen der Source- und Drain-Elektrode. Insbesondere kann sich innerhalb des erfindungsgemäßen Strahlungsdetektors monolithisch eingebettet ein aktiver Halbleiter befinden, welcher die THz-Strahlung in einen niedrigen Frequenzbereich bis hinab zu Gleichstrom umsetzt.

Ein weiterer Aspekt der vorliegenden Erfindung betrifft ein Verfahren zum Herstellen eines Strahlungsdetektors. Das erfindungsgemäße Verfahren umfasst das Bereitstellen einer auf einem Substrat angeordneten Feldeffekttransistor-Struktur (FET-Struktur) mit einem Gate-Bereich, einem Source-Bereich und einem Drain-Bereich; die Metallisierung des Gate-Bereichs, des Source-Bereichs und des Drain-Bereichs, wobei voneinander unabhängige, elektrisch leitfähige Elektrodenstrukturen ausbildet werden, wobei durch die Gate-Elektrodenstruktur entweder die Source-Elektrodenstruktur oder die Drain-Elektrodenstruktur in einer ersten Ebene vollständig umschlossen wird, wobei die umschlossene Elektrodenstruktur bis oberhalb der Gate-Elektrodenstruktur erstreckt wird und durch die umschlossene Elektrodenstruktur die Umschließung in einer zweiten Ebene oberhalb der ersten Ebene zumindest abschnittsweise flächig überdeckt wird, wobei zwischen den von der umschlossenen Elektrodenstruktur überdeckten Bereichen der Gate-Elektrodenstruktur ein elektrisch isolierender Bereich zur Ausbildung eines Kondensators mit einer Metall-Isolator-Metall-, MIM-, Struktur angeordnet wird; und Strukturierung einer auf dem Substrat angeordneten Antennenstruktur, wobei die Antennenstruktur auf dem Substrat aufliegend unmittelbar von den Elektrodenstrukturen ausgebildet wird, wobei eine strahlende Öffnung innerhalb einer Metallfläche der Antennenstruktur ausgebildet wird und wobei der Fußpunkt der Antennenstruktur zwischen dem Gate-Bereich (26) und dem Source-Bereich (24) oder zwischen dem Gate-Bereich (26) und dem Drain-Bereich (28) angeordnet wird. Vorzugsweise wird der Fußpunkt der Antennenstruktur zwischen dem Gate-Bereich und dem Source- bzw. Drain-Bereich nicht umschlossenen Elektrodenstruktur angeordnet.

Das erfindungsgemäße Verfahren ist dazu geeignet, besonders bevorzugte Ausführungsformen eines erfindungsgemäßen Strahlungsdetektors zur Verfügung zu stellen. Zweckmäßige Ausgestaltungen der Erfindung sind in den Unteransprüchen enthalten.

Vorzugsweise wird die Antennenstruktur 2-armig oder 4-armig strukturiert ausgebildet. Ebenfalls nur vorzugsweise können der Kondensator und die Antennenstruktur in ihren Resonanzfrequenzen zur Ausbildung einer gemeinsamen HF-Umgebung auf den Empfang von elektromagnetischen Wellen im THz-Bereich aufeinander abgestimmt werden.

### Kurzbeschreibung der Zeichnungen

Die Erfindung wird nachfolgend in Ausführungsbeispielen anhand der zugehörigen Zeichnung erläutert. Es zeigen:
- Fig. 1a: einen schematischen Aufbau einer exemplarischen Ausführungsform einer erfindungsgemäßen FET-Struktur in der Seitenansicht,
- Fig. 1b: einen abstrakten schematischen Aufbau einer erfindungsgemäßen FET-Struktur in der Seitenansicht,
- Fig. 2a, 2b: einen abstrakten schematischen Aufbau einer erfindungsgemäßen FET-Struktur nach Fig. 1b in der Seitenansicht (a) und in der Aufsicht (b),
- Fig. 3: einen schematischen Aufbau einer ersten Ausführungsform der Erfindung (Hole-Antenne),
- Fig. 4: einen schematischen Aufbau einer zweiten Ausführungsform der Erfindung (Teardrop-Antenne),
- Fig. 5: einen schematischen Aufbau einer dritten Ausführungsform der Erfindung (Schlitz-Patch-Antenne),
- Fig. 6: einen schematischen Aufbau einer vierten Ausführungsform der Erfindung (Schlitz-Bowtie-Antenne, Variante 1),
- Fig. 7: einen schematischen Aufbau einer fünften Ausführungsform der Erfindung (Schlitz-Bowtie-Antenne, Variante 2),
- Fig. 8: einen schematischen Aufbau einer sechsten Ausführungsform der Erfindung (Schlitz-Iog-Spiral-Antenne),
- Fig. 9: einen schematischen Aufbau einer siebenten Ausführungsform der Erfindung (Schlitz-Bowtie-Antenne, 4-armig), und
- Fig. 10: einen schematischen Aufbau einer achten Ausführungsform der Erfindung (Schlitz-Iog-Spiral-Antenne, 4-armig).

### Ausführliche Beschreibung der Zeichnungen

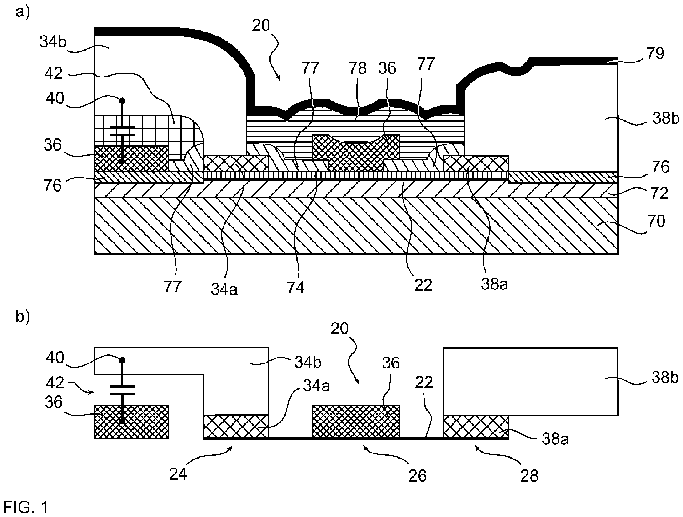

Fig. 1a zeigt einen schematischen Aufbau einer exemplarischen Ausführungsform einer erfindungsgemäßen FET-Struktur 20 in der Seitenansicht. Bei anderen Ausführungsformen der Erfindung können insbesondere die konkrete Ausformung sowie die gegenseitige Anordnung der dargestellten Elemente von der hier gezeigten Struktur abweichen. Ebenfalls werden durch die gezeigte Darstellung kein konkreter Schichtaufbau oder ein bestimmtes Verfahren zur Herstellung des entsprechenden Schichtaufbaus nahegelegt. Die erfindungsgemäße FET-Struktur 20 kann im Rahmen dieser Offenbarung beliebig variiert werden und wird durch die gezeigte Darstellung in keiner Weise eingeschränkt.

Die gezeigte Ausführungsform basiert auf einer zur Herstellung von FETs geeigneten Epitaxiestruktur und weist ein Substrat 70 (z.B. aus SiC) mit einer darauf angeordneten Pufferschicht 72 (z.B. eine GaN-Pufferschicht) auf. Auf der Pufferschicht 72 ist ein aktives Gebiet 74 (z.B. aus AIGaN) angeordnet. Das aktive Gebiet 74 wird seitlich durch eine Isolationsschicht 76 begrenzt. Bei einem FET erfolgt eine Steuerung des Stromflusses innerhalb des aktiven Gebiets 74. Dabei bildet sich im Betrieb des FET im Allgemeinen im Grenzbereich zwischen dem aktiven Gebiet 74 und der Pufferschicht 72 ein 2-dimensionales Elektronengas aus, welches als 2DEG 22 bezeichnet wird. Eine elektronische Ansteuerung des aktiven Gebiets 74 erfolgt von oberhalb des aktiven Gebietes 74 über drei voneinander unabhängige, elektrisch leitfähige Elektroden, welche typischerweise als Gate, Source und Drain bezeichnet werden. Diese Elektroden weisen entsprechend eine Source-Elektrodenstruktur 34, eine Gate-Elektrodenstruktur 36 und eine Drain-Elektrodenstruktur 38 auf. Durch die Elektroden wird im aktiven Gebiet 72 bzw. innerhalb des 2DEG 22 ein Source-Bereich 24, ein Gate-Bereich 26 und ein Drain-Bereich 28 definiert. Ein typischer Wert für die Länge des Gate-Bereichs 26 liegt etwa bei 100 nm, wobei die Gate-Elektrodenstruktur 36 im Bereich oberhalb des Gate-Bereichs 26 typischerweise eine Länge von etwa 200 nm aufweist. Typische Längen für den Abstand zwischen der Gate-Metallisierung 36 und dem ohmschen Source-Kontakt 34a bzw. zwischen der Gate-Metallisierung 36 und dem ohmschen Drain-Kontakt 38a liegen zwischen 0,1 µm und 1 µm. Dabei können sowohl symmetrische als auch asymmetrische Ausführungsformen realisiert werden.

Die einzelnen Elektrodenstrukturen 34, 36, 38 können aus einer einzigen Schicht bzw. einem einheitlichen Material (vorzugsweise einem elektrisch leitfähigen metallischen Material) bestehen oder aus einer Schichtung bzw. Kombination unterschiedlicher Materialien aufgebaut sein. Insbesondere zeigt die Darstellung eine aus einem einheitlichen Material bestehende Gate-Elektrode 36 (z.B. aus einer Legierung aus unterschiedlichen Metallen). Die Source-Elektrodenstruktur 34 sowie die Drain-Elektrodenstruktur 38 sind hingegen schichtweise aufeinanderliegend aufgebaut. Die Source-Elektrodenstruktur 34 setzt sich dabei aus einem unmittelbar auf dem aktiven Gebiet 74 aufliegenden ohmschen Source-Kontakt 34a und einer unmittelbar darüber angeordneten Source-Metallisierung 34b (z.B. durch Aufdampfen oder Abscheiden insbesondere von Au) zusammen. Entsprechend ist die Drain-Elektrodenstruktur 38 aus einem unmittelbar auf dem aktiven Gebiet 74 aufliegenden ohmschen Drain-Kontakt 38a und einer unmittelbar darüber angeordneten Drain-Metallisierung 38b zusammengesetzt. Um die einzelnen Elektrodenstrukturen 34, 36, 38 elektrisch voneinander zu isolieren bzw. zu schützen, sind im oberen Bereich der Darstellung die Elektrodenstrukturen 34, 36, 38 von mehreren Passivierungsschichten 77, 78, 79 eingefasst bzw. gegeneinander abgegrenzt.

Unterhalb der Source-Metallisierung 34b ist erfindungsgemäß ein elektrisch isolierender Bereich 42 (Dielektrikum) angeordnet. Bei dem isolierenden Bereich 42 kann es sich beispielsweise um eine Isolationsschicht oder einen Freibereich (z.B. einen Luftspalt) handeln. Unterhalb des eingezeichneten isolierenden Bereichs 42 befindet sich eine Fortsetzung der Gate-Elektrodenstruktur 36. Es handelt sich hierbei um Abschnitte ein- und derselben Gate-Elektrodenstruktur 36. Insbesondere sind die beiden Abschnitte elektrisch leitend miteinander verbunden, wobei diese Verbindung der gezeigten Seitenansicht nicht zu entnehmen ist.

Zwischen dem von der Source-Metallisierung 34b überdeckten Bereichen der Gate-Elektrodenstruktur 36, d.h. dem links in der Darstellung befindlichen Abschnitt der Gate-Elektrodenstruktur 36, ist somit ein elektrisch isolierender Bereich 42 angeordnet. Die hierdurch erzeugte Metall-Isolator-Metall-Schichtung (MIM-Schichtung) bildet einen Kondensator 40 mit einer entsprechenden MIM-Struktur aus. Zur Verdeutlichung der strukturellen Zusammenhänge ist an der entsprechenden Stelle das übliche technische Schaltzeichen für einen Kondensator in den schematischen Aufbau mit eingezeichnet.

Fig. 1b zeigt einen abstrakten schematischen Aufbau einer erfindungsgemäßen FET-Struktur 20 in der Seitenansicht. Im Gegensatz zur Fig. 1a handelt es sich um eine auf die wesentlichen Elemente der FET-Struktur 20 reduzierte Darstellung mit erhöhtem Abstraktionsgrad. Auf eine explizite Darstellung von etwaigen Isolations-, Träger- und Zwischenschichten wurde verzichtet. Bei dem gezeigten Aufbau kann es sich insbesondere um eine abstrakte Darstellung der in Fig. 1a gezeigten exemplarischen Ausführungsform einer erfindungsgemäßen FET-Struktur 20 in der Seitenansicht handeln. Die jeweiligen Bezugszeichen und deren Zuordnung gelten daher entsprechend.

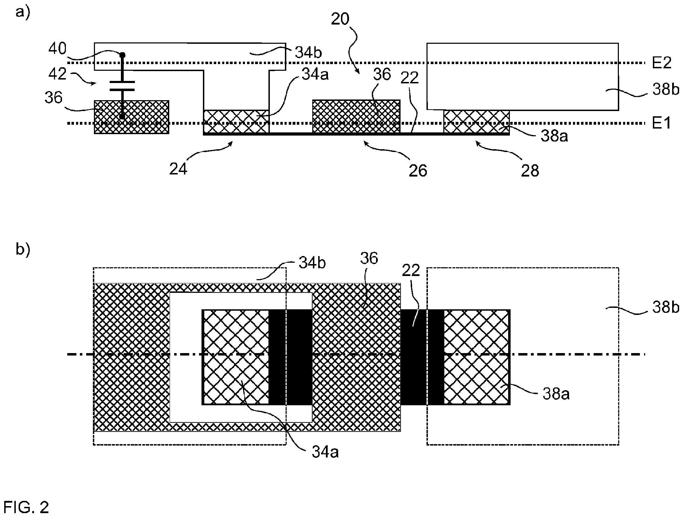

Fig. 2a zeigt einen abstrakten schematischen Aufbau einer erfindungsgemäßen FET-Struktur 20 nach Fig. 1b in der Seitenansicht. Die jeweiligen Bezugszeichen und deren Zuordnung gelten entsprechend. Weiterhin eingezeichnet sind eine erste Ebene E1 und eine zweite Ebene E2, wobei die zweite Ebene E2 oberhalb der ersten Ebene E1 angeordnet ist.

Fig. 2b zeigt einen abstrakten schematischen Aufbau einer exemplarischen Ausführungsform einer erfindungsgemäßen FET-Struktur 20 nach Fig. 2a in der Aufsicht. Die in Fig. 2b eingezeichnete Strichpunktline gibt dabei eine Schnittgerade an, die zu einer in Fig. 2a gezeigten Seitenansicht führt.

Die Figuren 2a und 2b zeigen somit eine FET-Struktur 20 mit einem Source-Bereich 24, einem Gate-Bereich 26, und einem Drain-Bereich 28, wobei diese Bereiche 24, 26, 28 durch Metallisierung voneinander unabhängige elektrisch leitfähige Elektrodenstrukturen 34, 36, 38 ausbilden; wobei die Gate-Elektrodenstruktur 36 die Source-Elektrodenstruktur 34 in einer ersten Ebene E1 vollständig umschließt; sich die umschlossene Source-Elektrodenstruktur 34 bis oberhalb der Gate-Elektrodenstruktur 36 erstreckt und dort die Umschließung in einer zweiten Ebene E2 oberhalb der ersten Ebene E1 zumindest abschnittsweise flächig überdeckt (im schraffiert umrandet eingezeichneten Bereich der Source-Metallisierung 34b); wobei zwischen den von der umschlossenen Source-Elektrodenstruktur 34 überdeckten Bereichen der Gate-Elektrodenstruktur 36 (im Wesentlichen der vom schraffiert umrandet eingezeichneten Bereich der Source-Metallisierung 34b überdeckte Bereich der Gate-Elektrodenstruktur 36) ein elektrisch isolierender Bereich 42 zur Ausbildung eines Kondensators 40 mit einer MIM-Struktur angeordnet ist.

Die Gate-Elektrodenstruktur 36 in der ersten Ebene E1 und die umschlossene Source-Elektrodenstruktur 34 in der zweiten Ebene E2 überdecken sich in der gezeigten Darstellung im Wesentlichen als rechteckige Flächenelemente (linksseitiger rechteckiger Abschnitt der zweiteilig verbunden Gate-Elektrodenstruktur 36). Durch gestrichelte Umrandungen, insbesondere bei der Source-Metallisierung 34b, soll jedoch angedeutet werden, dass sich diese Bereiche auch weiter als eingezeichnet erstrecken können. Bei anderen Ausführungsformen können zur Ausbildung einer angepassten HF-Umgebung oder zur Anpassung der HF-Umgebung an eine bestimmte Antennenstruktur 10 die geometrischen Abmessungen (Längen, Höhen und/oder Breiten) der Source-Elektrodenstruktur 34 und der Gate-Elektrodenstruktur 38 einzeln und in Bezug zueinander variiert werden. Insbesondere können der ohmsche Source-Kontakt 34a und der ohmsche Drain-Kontakt 38a jeweils unterschiedliche Breiten aufweisen, wobei die Breite der nur in einer Aufsicht ersichtlichen Dimension entspricht (die Höhe entspricht der Höhe in einer Seitenansicht).

Im Übrigen kann erfindungsgemäß anstelle der Source-Elektrodenstruktur 34 alternativ auch die Drain-Elektrodenstruktur 38 umschlossen sein.

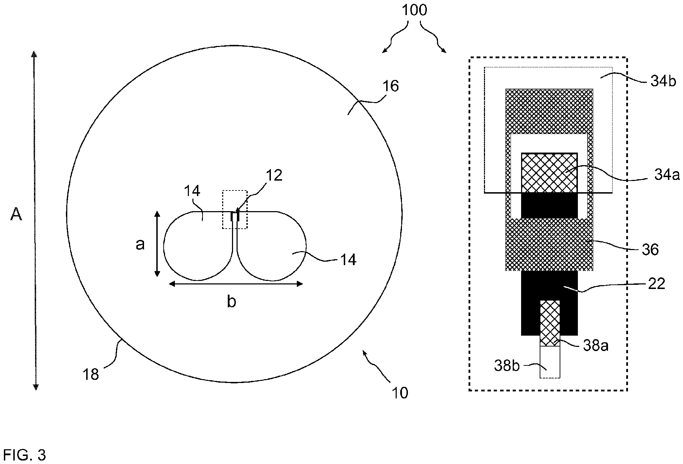

Fig. 3 zeigt einen schematischen Aufbau einer ersten Ausführungsform der Erfindung (Hole-Antenne). Insbesondere zeigt die Darstellung eine bevorzugte Antennenstruktur 10 eines erfindungsgemäßen Strahlungsdetektors 100. Die Antennenstruktur 10 kann auf einem Substrat 70 aufliegend unmittelbar von Elektrodenstrukturen 34, 36, 38 ausgebildet werden. Vorzugsweise ist zwischen der Antennenstruktur und dem Substrat eine Epitaxiestruktur (z.B. die in Fig. 1a gezeigte Epitaxiestruktur) angeordnet. Vorzugsweise wird die Antennenstruktur 10 unmittelbar von der Source-Elektrodenstruktur 34 und/oder der Drain-Elektrodenstruktur 38 ausgebildet.

Der Fußpunkt 12 der Antennenstruktur 10 kann zwischen dem Gate-Bereich 26 der Gate-Elektrodenstruktur 36 und dem Drain-Bereich 28 der Drain-Elektrodenstruktur 38 angeordnet sein. Die Antennenstruktur 10 weist zwei annähernd kreisrunde Öffnungen 14 innerhalb einer Metallfläche 16 auf, wobei sich im Bereich zwischen den beiden Öffnungen 14 ein schmaler Streifen erstreckt. Wie in der nebenstehenden abstrakt-schematischen Darstellung der aus dem inneren Bereich der Antennenstruktur 10 vergrößerten FET-Struktur 20 gezeigt, wird dieser Teil der Metallfläche 16 unmittelbar von der Drain-Metallisierung 38b ausgebildet und ist somit zur Drain-Elektrodenstruktur 38 gehörig. Der obere halbkreisförmige Teilbereich der Metallfläche 16 wird hingegen unmittelbar von der Source-Metallisierung 34b ausgebildet und ist somit zur Source-Elektrodenstruktur 34 gehörig. Wie der gezeigten Darstellung ebenfalls entnommen werden kann, weichen im Bereich der FET-Struktur 20 die Breite des ohmschen Source-Kontaktes 34a und des ohmschen Drain-Kontaktes 38a voneinander ab.

Vorzugsweise haben der ohmsche Source-Kontakt 34a und der ohmsche Drain-Kontakt 38a eine Höhe zwischen 0,1 µm und 0,5 µm. Bevorzugter ist eine Höhe von etwa 0,25 µm. Eine bevorzugte Länge des ohmschen Source-Kontaktes 34a liegt bei größer als 3 µm. Bevorzugter ist eine Länge zwischen 4 µm und 6 µm. Vorzugsweise haben der ohmsche Source-Kontakt 34a und der ohmsche Drain-Kontakt 38a eine Breite größer als 1 µm. Bevorzugter ist eine Breite zwischen 3 µm und 4 µm.

Vorzugsweise hat die Gate-Elektrodenstruktur 36 eine Höhe zwischen 0,3 µm und 0,5 µm. Bevorzugter ist eine Höhe von etwa 0,35 µm. Vorzugsweise hat die Source-Metallisierung 34a im Bereich des Kondensators 40 eine Höhe zwischen 0,5 µm und 1,2 µm. Bevorzugter ist eine Höhe von etwa 0,65 µm. Vorzugsweise haben die Source-Metallisierung 34b und die Drain-Metallisierung 38b im Bereich des Kondensators 40 eine Breite größer als 3 µm. Bevorzugter ist eine Breite zwischen 4 µm und 6 µm.

Vorzugsweise hat der elektrisch isolierende Bereich 42 eine Höhe zwischen 0,01 µm und 0,5 µm. Bevorzugter ist eine Höhe von etwa 0,2 µm.

Die gezeigte Antennenstruktur 10 zeichnet sich insbesondere durch eine zirkulare Formgebung der Öffnungen 14 aus. Der Kondensator 40 und die Antennenstruktur 10 können eine gemeinsame HF-Umgebung ausbilden, die dazu eingerichtet ist, den erfindungsgemäßen Strahlungsdetektor 100 auf den Empfang von elektromagnetischen Wellen im THz-Bereich abzustimmen. Insbesondere kann bei der gezeigten Antennenstruktur 10 mit einer Au-Metallfläche 16, einem ersten Öffnungsabschnitt a von etwa 14,6 µm, einem zweiten Öffnungsabschnitt b von etwa 30 µm und einem variablen Antennenabschnitt A eine Abstimmung der Empfangseigenschaften auf den spektralen Bereich um etwa 1 THz erfolgen. Vorzugsweise werden dabei auf dem äußeren Rand 18 der Antennenstruktur 10 HF-Ströme mit Frequenzen größer als 100 GHz kurzgeschlossenen. Durch die Antennenstruktur 10 wird somit ein HF-Kurzschluss zwischen 2 der 3 Bereiche 24, 26, 28 der FET-Struktur 20 realisiert. Insbesondere kann durch die Antennenstruktur 10 ein HF-Kurzschluss zwischen dem Source-Bereich 24 und dem Drain-Bereich 28 der FET-Struktur 20 realisiert werden.

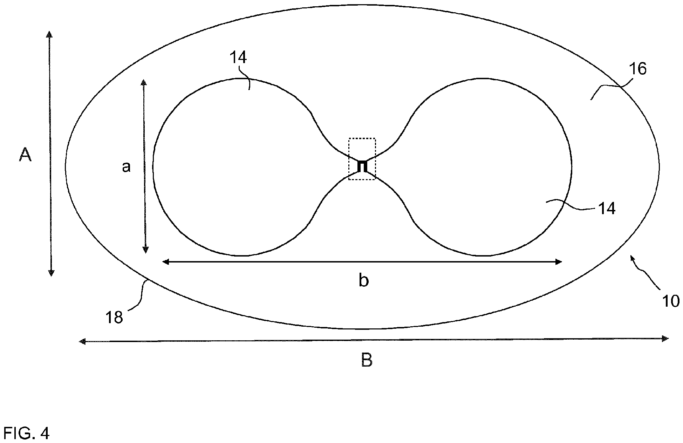

Fig. 4 zeigt einen schematischen Aufbau einer zweiten Ausführungsform der Erfindung (Teardrop-Antenne). Die gezeigte Darstellung entspricht bis auf den Antennentyp im Wesentlichen der in Fig. 3 gezeigten Darstellung. Die Bezugszeichen und deren Zuordnung gelten entsprechend. Auf eine abstrakt-schematische Darstellung der aus dem inneren Bereich der Antennenstruktur 10 vergrößerten FET-Struktur 20 wurde verzichtet; diese kann der Fig. 3 analog entnommen werden.

Die gezeigte Antennenstruktur 10 zeichnet sich insbesondere durch eine elliptische Formgebung des äußeren Randes 18 und eine tränenförmige Formgebung der Öffnungen 14 aus. Der Kondensator 40 und die Antennenstruktur 10 können eine gemeinsame HF-Umgebung ausbilden, die dazu eingerichtet ist, den erfindungsgemäßen Strahlungsdetektor 100 auf den Empfang von elektromagnetischen Wellen im THz-Bereich abzustimmen. Insbesondere kann bei der gezeigten Antennenstruktur 10 mit einer Au-Metallfläche 16, einem ersten Öffnungsabschnitt a von etwa 60 µm, einem zweiten Öffnungsabschnitt b von etwa 195 µm, einem ersten Antennenabschnitt A von etwa 125 µm und einem zweiten Antennenabschnitt B von etwa 275 µm eine breitbandige Abstimmung der Empfangseigenschaften auf den spektralen Bereich zwischen etwa 400 GHz und 2 THz erfolgen.

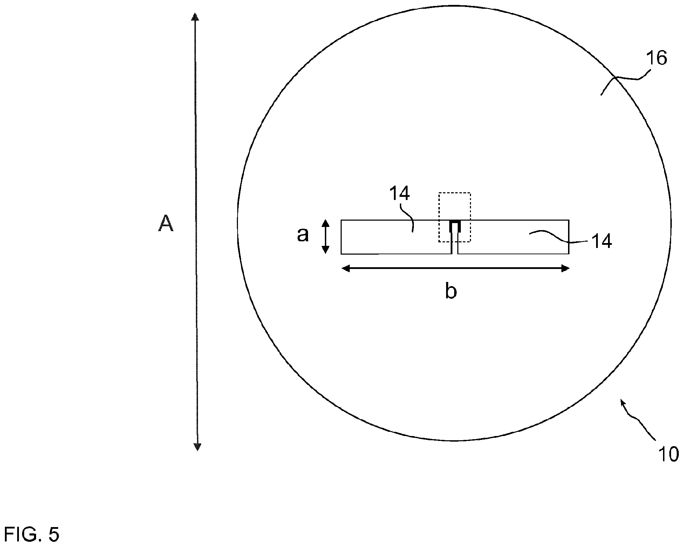

Fig. 5 zeigt einen schematischen Aufbau einer dritten Ausführungsform der Erfindung (Schlitz-Patch-Antenne). Die gezeigte Darstellung entspricht bis auf den Antennentyp im Wesentlichen der in Fig. 3 gezeigten Darstellung. Die Bezugszeichen und deren Zuordnung gelten entsprechend. Auf eine abstrakt-schematische Darstellung der aus dem inneren Bereich der Antennenstruktur 10 vergrößerten FET-Struktur 20 wurde verzichtet; diese kann der Fig. 3 analog entnommen werden.

Die gezeigte Antennenstruktur 10 zeichnet sich insbesondere durch eine gestreckte Formgebung der Öffnungen 14 aus. Der Kondensator 40 und die Antennenstruktur 10 können eine gemeinsame HF-Umgebung ausbilden, die dazu eingerichtet ist, den erfindungsgemäßen Strahlungsdetektor 100 auf den Empfang von elektromagnetischen Wellen im THz-Bereich abzustimmen. Insbesondere kann bei der gezeigten Antennenstruktur 10 mit einer Au-Metallfläche 16, einem zweiten Öffnungsabschnitt b von etwa 94 µm und einem ersten Antennenabschnitt A von etwa 155 µm und einem zweiten Antennenabschnitt B von etwa 275 µm eine Abstimmung der Empfangseigenschaften auf den spektralen Bereich um etwa 600 GHz erfolgen.

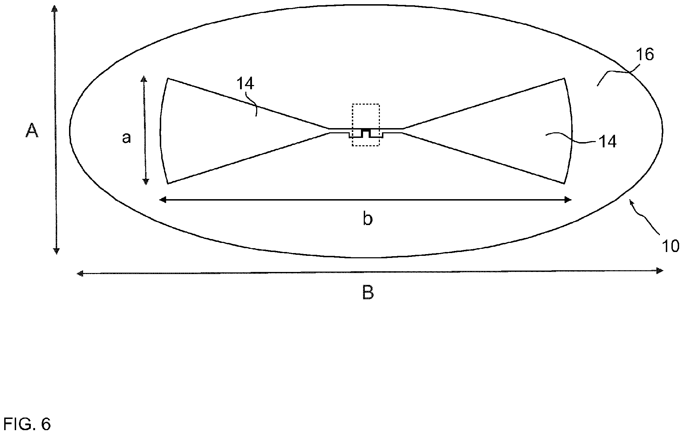

Fig. 6 zeigt einen schematischen Aufbau einer vierten Ausführungsform der Erfindung (Schlitz-Bowtie-Antenne, Variante 1). Die gezeigte Darstellung entspricht bis auf den Antennentyp im Wesentlichen der in Fig. 3 gezeigten Darstellung. Die Bezugszeichen und deren Zuordnung gelten entsprechend. Auf eine abstrakt-schematische Darstellung der aus dem inneren Bereich der Antennenstruktur 10 vergrößerten FET-Struktur 20 wurde verzichtet; diese kann der Fig. 3 analog entnommen werden.

Die gezeigte Antennenstruktur 10 zeichnet sich insbesondere durch eine gestreckte, sich in zwei Richtungen erweiternde Formgebung der Öffnungen 14 aus. Der Kondensator 40 und die Antennenstruktur 10 können eine gemeinsame HF-Umgebung ausbilden, die dazu eingerichtet ist, den erfindungsgemäßen Strahlungsdetektor 100 auf den Empfang von elektromagnetischen Wellen im THz-Bereich abzustimmen. Insbesondere kann bei der gezeigten Antennenstruktur 10 mit einer Au-Metallfläche 16, einem ersten Öffnungsabschnitt a von etwa 146 µm, einem ersten Antennenabschnitt A von etwa 90 µm und einem zweiten Antennenabschnitt B von etwa 210 µm eine breitbandige Abstimmung der Empfangseigenschaften auf den spektralen Bereich zwischen etwa 500 GHz und 2 THz erfolgen.

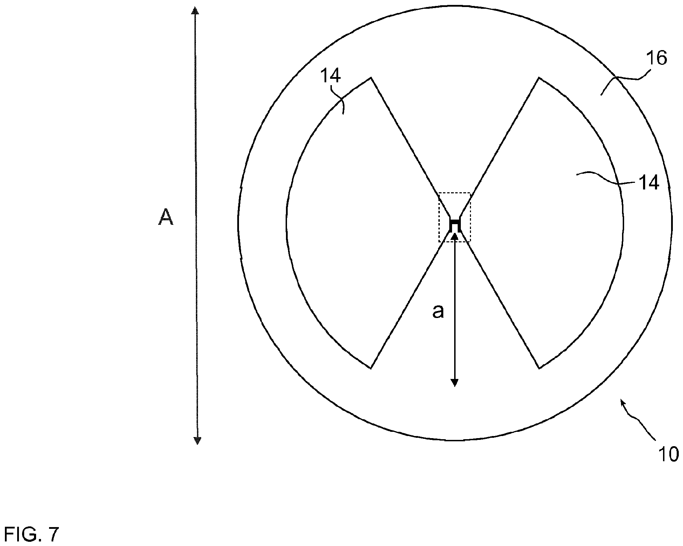

Fig. 7 zeigt einen schematischen Aufbau einer fünften Ausführungsform der Erfindung (Schlitz-Bowtie-Antenne, Variante 2). Die gezeigte Darstellung entspricht bis auf den Antennentyp im Wesentlichen der in Fig. 3 gezeigten Darstellung. Die Bezugszeichen und deren Zuordnung gelten entsprechend. Auf eine abstrakt-schematische Darstellung der aus dem inneren Bereich der Antennenstruktur 10 vergrößerten FET-Struktur 20 wurde verzichtet; diese kann der Fig. 3 analog entnommen werden.

Die gezeigte Antennenstruktur 10 zeichnet sich insbesondere durch eine partiell zirkulare, sich in zwei Richtungen erweiternde Formgebung der Öffnungen 14 aus. Der Kondensator 40 und die Antennenstruktur 10 können eine gemeinsame HF-Umgebung ausbilden, die dazu eingerichtet ist, den erfindungsgemäßen Strahlungsdetektor 100 auf den Empfang von elektromagnetischen Wellen im THz-Bereich abzustimmen. Insbesondere kann bei der gezeigten Antennenstruktur 10 mit einer Au-Metallfläche 16, einem ersten Öffnungsabschnitt a von etwa 140 µm und einem ersten Antennenabschnitt A von etwa 360 µm eine breitbandige Abstimmung der Empfangseigenschaften auf den spektralen Bereich zwischen etwa 400 GHz und 2 THz erfolgen.

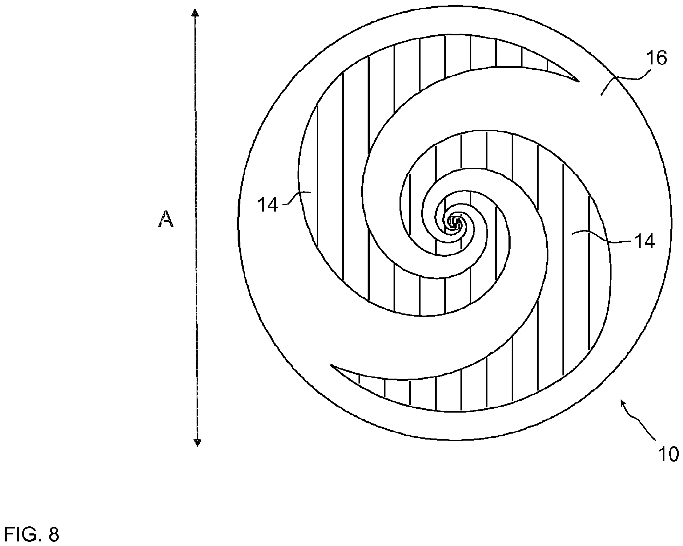

Fig. 8 zeigt einen schematischen Aufbau einer sechsten Ausführungsform der Erfindung (Schlitz-Iog-Spiral-Antenne). Die gezeigte Darstellung entspricht bis auf den Antennentyp im Wesentlichen der in Fig. 3 gezeigten Darstellung. Die Bezugszeichen und deren Zuordnung gelten entsprechend. Auf die abstrakt-schematische Darstellung der aus dem inneren Bereich der Antennenstruktur 10 vergrößerten FET-Struktur 20 wurde verzichtet; diese kann der Fig. 3 analog entnommen werden. Für eine bessere Sichtbarkeit der Spiralstruktur ist der Bereich der Öffnungen 14 schraffiert dargestellt.

Die gezeigte Antennenstruktur 10 zeichnet sich insbesondere durch eine sich spiralförmig um den Fußpunkt 12 der Antennenstruktur 10 erweiternde Formgebung der Öffnungen 14 aus. Der Kondensator 40 und die Antennenstruktur 10 können eine gemeinsame HF-Umgebung ausbilden, die dazu eingerichtet ist, den erfindungsgemäßen Strahlungsdetektor 100 auf den Empfang von elektromagnetischen Wellen im THz-Bereich abzustimmen. Insbesondere kann bei der gezeigten Antennenstruktur 10 mit einer Au-Metallfläche 16 und einem ersten Antennenabschnitt A von etwa 610 µm eine breitbandige Abstimmung der Empfangseigenschaften auf den spektralen Bereich zwischen etwa 300 GHz und 3 THz erfolgen.

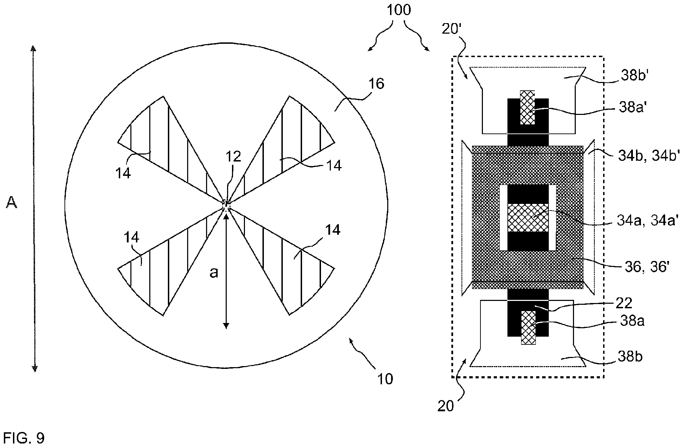

Fig. 9 zeigt einen schematischen Aufbau einer siebenten Ausführungsform der Erfindung (Schlitz-Bowtie-Antenne, 4-armig). Der grundlegende Aufbau der gezeigten Antennenstruktur 10 entspricht im Wesentlichen dem in Fig. 7 dargestellten Antennentyp. Die Bezugszeichen und deren Zuordnung gelten entsprechend. Im Unterschied zur Fig. 7 handelt es sich bei dieser Ausführungsform jedoch nicht um eine 2-armige Antennenstruktur (zwei Öffnungen 14 sind symmetrisch um den Fußpunkt 12 der Antennenstruktur 10 angeordnet), vielmehr liegt hier eine 4-armige Anordnung der Strukturelemente vor (vier Öffnungen 14 sind symmetrisch um den Fußpunkt 12 der Antennenstruktur 10 angeordnet). Für eine bessere Sichtbarkeit der Struktur ist der Bereich der Öffnungen 14 schraffiert dargestellt. Die ebenfalls eingezeichnete abstrakt-schematische Darstellung der aus dem inneren Bereich der Antennenstruktur 10 vergrößerten FET-Strukturen 20, 20' stellt eine bevorzugte Ausführungsform für eine entsprechende Anordnung von zwei parallel geschalteten FET-Strukturen 20, 20' dar. Beide FET-Strukturen 20, 20' können insbesondere auf einem gemeinsamen Substrat 70 angeordnet sein, wobei die Antennenstruktur 10 unmittelbar von den Elektrodenstrukturen 34, 34', 38, 38' ausgebildet wird. Vorzugsweise ist zwischen der Antennenstruktur und dem Substrat eine Epitaxiestruktur (z.B. die in Fig. 1a gezeigte Epitaxiestruktur) angeordnet.

In der gezeigten Ausführungsform bilden die beiden FET-Strukturen 20, 20' ein gemeinsames 2DEG 22 aus. Zudem weisen beide FET-Strukturen 20, 20' eine gemeinsame Source-Elektrodenstruktur 34, 34' (d.h. gemeinsame ohmsche Source-Kontakte 34a, 34a' und Source-Metallisierungen 34b, 34b') auf. Jeweils an den Enden des 2DEG 22 sind die Drain-Elektrodenstruktur 38 (umfassend einen ohmschen Drain-Kontakt 38a und eine Drain-Metallisierung 38b) der ersten FET-Struktur 20 sowie die Drain-Elektrodenstruktur 38' (umfassend einen ohmschen Drain-Kontakt 38a' und eine Drain-Metallisierung 38b') angeordnet. Die jeweiligen Gate-Bereiche 26, 26' der beiden FET-Strukturen 20, 20' sind über eine gemeinsame Gate-Elektrodenstruktur 36, 36' elektrisch leitend miteinander verbunden.

Dabei umschließen erfindungsgemäß die Gates der beiden FET-Strukturen 20, 20' über eine gemeinsame Gate-Elektrodenstruktur 36, 36' die gemeinsame Source-Elektrodenstruktur 34, 34' in einer ersten Ebene E1 vollständig (doppelte Umschließung), wobei sich die umschlossene gemeinsame Source-Elektrodenstruktur 34, 34' bis oberhalb der (die beiden Gate-Bereiche 26, 26' der beiden FET-Strukturen 20,20' elektrisch leitend miteinander verbindenden) Gate-Elektrodenstruktur 36, 36' erstreckt und dort die (doppelte) Umschließung in einer zweiten Ebene E2 oberhalb der ersten Ebene E1 zumindest abschnittsweise flächig überdeckt, wobei zwischen den von der gemeinsame Source-Elektrodenstruktur 34, 34' überdeckten Bereichen besagter Gate-Elektrodenstruktur 36, 36' ein elektrisch isolierender Bereich 42 zur Ausbildung eines Kondensators 40 mit einer MIM-Struktur angeordnet ist.

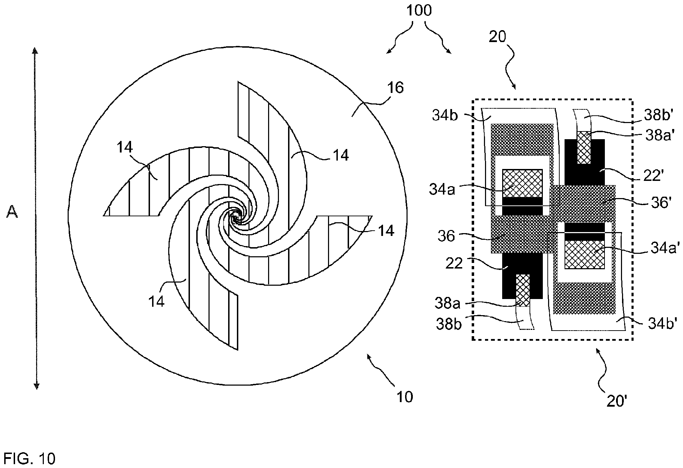

Fig. 10 zeigt einen schematischen Aufbau einer achten Ausführungsform der Erfindung (Schlitz-Iog-Spiral-Antenne, 4-armig). Der grundlegende Aufbau der gezeigten Antennenstruktur 10 entspricht im Wesentlichen dem in Fig. 8 dargestellten Antennentyp. Die Bezugszeichen und deren Zuordnung gelten entsprechend. Im Unterschied zur Fig. 8 handelt es sich bei dieser Ausführungsform jedoch nicht um eine 2-armige Antennenstruktur (zwei Öffnungen 14 sind symmetrisch um den Fußpunkt 12 der Antennenstruktur 10 angeordnet), vielmehr liegt hier eine 4-armige Anordnung der Antennenelemente vor (vier Öffnungen 14 sind symmetrisch um den Fußpunkt 12 der Antennenstruktur 10 angeordnet). Für eine bessere Sichtbarkeit der Spiralstruktur ist der Bereich der Öffnungen 14 schraffiert dargestellt. Die ebenfalls eingezeichnete abstrakt-schematische Darstellung der aus dem inneren Bereich der Antennenstruktur 10 vergrößerten FET-Strukturen 20, 20' stellt eine bevorzugte Ausführungsform für eine entsprechende Anordnung von zwei parallel geschalteten FET-Strukturen 20, 20' dar. Beide FET-Strukturen 20, 20' können insbesondere auf einem gemeinsamen Substrat 70 angeordnet sein, wobei die Antennenstruktur 10 unmittelbar von den Elektrodenstrukturen 34, 34', 38, 38' ausgebildet wird. Vorzugsweise ist zwischen der Antennenstruktur und dem Substrat eine Epitaxiestruktur (z.B. die in Fig. 1a gezeigte Epitaxiestruktur) angeordnet.

In der gezeigten Ausführungsform sind die beiden FET-Strukturen 20, 20' unmittelbar nebeneinander liegend angeordnet. Es handelt sich hierbei um voneinander unabhängige FET-Strukturen 20, 20', wobei die Gate-Bereiche 26, 26' der beiden FET-Strukturen 20, 20' über eine gemeinsame Gate-Metallisierung 36, 36' elektrisch leitend miteinander verbunden sind. MIM-Kondensatoren 40 werden in beiden FET-Strukturen 20, 20' jeweils von einem Teil der Gate-Elektrodenstruktur 36, 36' durch einen sich mit einem Teil der Source-Elektrodenstruktur 34, 34' überdeckenden Bereich ausgebildet.

### Bezugszeichenliste

- 10: Antennenstruktur
- 12: Fußpunkt
- 14: Öffnung
- 16: Metallfläche
- 18: äußerer Rand
- 20: FET-Struktur
- 22: 2DEG
- 24: Source-Bereich
- 26: Gate-Bereich
- 28: Drain-Bereich
- 34: Source-Elektrodenstruktur
- 34a: ohmscher Source-Kontakt
- 34b: Source-Metallisierung
- 36: Gate-Elektrodenstruktur
- 38: Drain-Elektrodenstruktur
- 38a: ohmscher Drain-Kontakt
- 38b: Drain-Metallisierung
- 40: Kondensator
- 42: elektrisch isolierender Bereich
- 70: Substrat
- 72: Pufferschicht
- 74: aktives Gebiet
- 76: Isolationsschicht
- 77, 78,79: Passivierungsschichten
- 100: Strahlungsdetektor

- A, B: Antennenabschnitte
- a, b: Öffnungsabschnitte
- E1: erste Ebene
- E2: zweite Ebene

## Patentansprüche

1. Strahlungsdetektor (100) umfassend:
a) eine Antennenstruktur (10); und
b) eine Feldeffekttransistor-, FET-, Struktur (20) mit einem Source-Bereich (24), einem Gate-Bereich (26), und einem Drain-Bereich (28),
c) wobei diese Bereiche (24, 26, 28) auf einem Substrat (70) angeordnet sind und durch Metallisierung voneinander unabhängige elektrisch leitfähige Elektrodenstrukturen (34, 36, 38) ausbilden;
**dadurch gekennzeichnet, dass**
d) die Gate-Elektrodenstruktur (36) die Source-Elektrodenstruktur (34) oder die Drain-Elektrodenstruktur (38) in einer ersten Ebene (E1) vollständig umschließt;
e) sich die umschlossene Elektrodenstruktur (34, 38) bis oberhalb der Gate-Elektrodenstruktur (36) erstreckt und dort die Umschließung in einer zweiten Ebene (E2) oberhalb der ersten Ebene (E1) zumindest abschnittsweise flächig überdeckt;
f) wobei zwischen den von der umschlossenen Elektrodenstruktur (34, 38) überdeckten Bereichen der Gate-Elektrodenstruktur (36) ein elektrisch isolierender Bereich (42) zur Ausbildung eines Kondensators (40) mit einer Metall-Isolator-Metall-, MIM-, Struktur angeordnet ist.

2. Strahlungsdetektor (100) nach Anspruch 1, wobei die Antennenstruktur (10) auf dem Substrat (70) aufliegend unmittelbar von Elektrodenstrukturen (34, 36, 38) ausgebildet ist.

3. Strahlungsdetektor (100) nach einem der vorhergehenden Ansprüche, wobei sich die Gate-Elektrodenstruktur (36) in der ersten Ebene (E1) und die umschließende Elektrodenstruktur (34, 38) in der zweiten Ebene (E2) im Wesentlichen als rechteckige Flächenelemente überdecken.

4. Strahlungsdetektor (100) nach einem der vorhergehenden Ansprüche, wobei die FET-Struktur (20) auf der Basis von Silizium oder einem III-V-Halbleiter aufgebaut ist.

5. Strahlungsdetektor nach einem der vorhergehenden Ansprüche, wobei der Fußpunkt (12) der Antennenstruktur (10) zwischen dem Gate-Bereich (26) und dem Source-Bereich (24) oder zwischen dem Gate-Bereich (26) und dem Drain-Bereich (28) angeordnet ist.

6. Strahlungsdetektor (100) nach einem der vorhergehenden Ansprüche, wobei die Antennenstruktur (10) eine Schlitzantenne ausbildet, wobei die Antennenstruktur (10) mindestens eine strahlende Öffnung (14) innerhalb einer Metallfläche (16) aufweist.

7. Strahlungsdetektor (100) nach einem der vorhergehenden Ansprüche, wobei auf dem äußeren Rand (18) der Antennenstruktur (10) Hochfrequenz-, HF-, Ströme mit Frequenzen größer als 100 GHz kurzgeschlossenen sind.

8. Strahlungsdetektor (100) nach einem der vorhergehenden Ansprüche, wobei die Antennenstruktur (10) einen HF-Kurzschluss zwischen 2 der 3 Bereiche (24, 26, 28) der FET-Struktur (20) realisiert.

9. Strahlungsdetektor (100) nach einem der vorhergehenden Ansprüche, wobei die Antennenstruktur (10) 2-armig oder 4-armig ausgebildet ist.

10. Strahlungsdetektor (100) nach einem der vorhergehenden Ansprüche, mindestens zwei parallel geschaltete FET-Strukturen (20) auf einem gemeinsamen Substrat (70) umfassend.

11. Strahlungsdetektor (100) nach einem der vorhergehenden Ansprüche, wobei der Kondensator (40) und die Antennenstruktur (10) eine gemeinsame HF-Umgebung ausbilden, dazu eingerichtet, den Strahlungsdetektor (100) auf den Empfang von elektromagnetischen Wellen im THz-Bereich abzustimmen.

12. Strahlungsdetektor (100) nach einem der vorhergehenden Ansprüche, weiterhin umfassend einen Frequenzumsetzer, wobei der Frequenzumsetzer die empfangene Strahlung in ein niederfrequentes Detektionssignal umsetzt.

13. Verfahren zur Herstellung eines Strahlungsdetektors (100), die folgenden Schritte umfassend:
- Bereitstellen einer auf einem Substrat (70) angeordneten Feldeffekttransistor-, FET-, Struktur (20) mit einem Gate-Bereich (26), einem Source-Bereich (24), und einem Drain-Bereich (28);
- Metallisierung des Gate-Bereichs (26), des Source-Bereichs (24) und des Drain-Bereichs (38), wobei voneinander unabhängige elektrisch leitfähige Elektrodenstrukturen (34, 36, 38) ausbildet werden, wobei durch die Gate-Elektrodenstruktur (36) entweder die Source-Elektrodenstruktur (34) oder die Drain-Elektrodenstruktur (38) in einer ersten Ebene (E1) vollständig umschlossen wird, wobei die umschlossene Elektrodenstruktur (34, 38) bis oberhalb der Gate-Elektrodenstruktur (36) erstreckt wird und durch die umschlossene Elektrodenstruktur (34, 38) die Umschließung in einer zweiten Ebene (E2) oberhalb der ersten Ebene (E1) zumindest abschnittsweise flächig überdeckt wird, wobei zwischen den von der umschlossenen Elektrodenstruktur (34, 38) überdeckten Bereichen der Gate-Elektrodenstruktur (36) ein elektrisch isolierender Bereich (42) zur Ausbildung eines Kondensators (40) mit einer Metall-Isolator-Metall-, MIM-, Struktur angeordnet wird; und
- Strukturierung einer auf dem Substrat (70) angeordneten Antennenstruktur (10), wobei die Antennenstruktur (10) auf dem Substrat (70) aufliegend unmittelbar von den Elektrodenstrukturen (34, 36, 38) ausgebildet wird, wobei eine strahlende Öffnung (14) innerhalb einer Metallfläche (16) der Antennenstruktur (10) ausgebildet wird und wobei der Fußpunkt (12) der Antennenstruktur (10) zwischen dem Gate-Bereich (26) und dem Source-Bereich (24) oder zwischen dem Gate-Bereich (26) und dem Drain-Bereich (28) angeordnet wird.

14. Verfahren zur Herstellung eines Strahlungsdetektors (100) nach Anspruch 13, wobei die Antennenstruktur 2-armig oder 4-armig strukturiert ausgebildet wird.

15. Verfahren zur Herstellung eines Strahlungsdetektors (100) nach Anspruch 13 oder 14, wobei der Kondensator (40) und die Antennenstruktur (10) in ihren Resonanzfrequenzen zur Ausbildung einer gemeinsamen HF-Umgebung auf den Empfang von elektromagnetischen Wellen im THz-Bereich aufeinander abgestimmt werden.

## Claims

1. A radiation detector (100) comprising:
a) an antenna structure (10); and
b) a field-effect transistor (FET) structure (20) with a source region (24), a gate region (26), and a drain region (28),
c) these regions (24, 26, 28) being arranged on a substrate (70) and forming mutually independent electrically conductive electrode structures (34, 36, 38) through metallization;
**characterized in that**
d) the gate electrode structure (36) completely encloses the source electrode structure (34) or the drain electrode structure (38) in a first plane (E1);
e) the enclosed electrode structure (34, 38) extends to above the gate electrode structure (36) where it overlaps the enclosure in a second plane (E2) above the first plane (E1) at least in places in planar manner;
f) wherein an electrically insulating region (42) for forming a capacitor (40) with a metal-insulator-metal (MIM) structure is arranged between the regions of the gate electrode structure (36) overlapped by the enclosed electrode structure (34, 38).

2. The radiation detector (100) according to Claim 1, wherein the antenna structure (10) lies on the substrate (70) and is formed directly by electrode structures (34, 36, 38).

3. The radiation detector (100) according to either one of the preceding claims, wherein the gate electrode structure (36) in the first plane (E1) and the enclosing electrode structure (34, 38) in the second plane (E2) substantially overlap as rectangular planar elements.

4. The radiation detector (100) according to any one of the preceding claims, wherein the FET structure (20) is constructed on the basis of silicon or a III-V semiconductor.

5. The radiation detector according to any one of the preceding claims, wherein the base point (12) of the antenna structure (10) is arranged between the gate region (26) and the source region (24) or between the gate region (26) and the drain region (28).

6. The radiation detector (100) according to any one of the preceding claims, wherein the antenna structure (10) forms a slot antenna, wherein the antenna structure (10) has at least one radiating opening (14) within a metal surface (16).

7. The radiation detector (100) according to any one of the preceding claims, wherein high-frequency (HF) currents with frequencies greater than 100 GHz are short-circuited on the outer edge (18) of the antenna structure (10).

8. The radiation detector (100) according to any one of the preceding claims, wherein the antenna structure (10) brings about an HF short circuit between 2 of the 3 regions (24, 26, 28) of the FET structure (20).

9. The radiation detector (100) according to any one of the preceding claims, wherein the antenna structure (10) is formed 2-armedly or 4-armedly.

10. The radiation detector (100) according to any one of the preceding claims, comprising at least two parallel-connected FET structures (20) on a common substrate (70).

11. The radiation detector (100) according to any one of the preceding claims, wherein the capacitor (40) and the antenna structure (10) form a common HF environment, configured to tune the radiation detector (100) to receive electromagnetic waves in the THz range.

12. The radiation detector (100) according to any one of the preceding claims, further comprising a frequency converter, wherein the frequency converter converts the received radiation into a low frequency detection signal.

13. A method for producing a radiation detector (100), comprising the following steps:
- providing a field-effect transistor (FET) structure (20) arranged on a substrate (70) and having a gate region (26), a source region (24), and a drain region (28);
- metallizing the gate region (26), the source region (24) and the drain region (38), wherein mutually independent electrically conductive electrode structures (34, 36, 38) are formed, wherein either the source electrode structure (34) or the drain electrode structure (38) is completely enclosed in a first plane (E1) by the gate electrode structure (36), wherein the enclosed electrode structure (34, 38) is extended to above the gate electrode structure (36) and the enclosure is overlapped in planar manner at least in places in a second plane (E2) above the first plane (E1) by the enclosed electrode structure (34, 38), wherein an electrically insulating region (42) is arranged between the regions of the gate electrode structure (36) overlapped by the enclosed electrode structure (34, 38) to form a capacitor (40) with a metal-insulator-metal (MIM) structure; and
- structuring an antenna structure (10) arranged on the substrate (70), wherein the antenna structure (10) is formed directly by the electrode structures (34, 36, 38) and lies on the substrate (70), wherein a radiating opening (14) is formed within a metal surface (16) of the antenna structure (10) and wherein the base point (12) of the antenna structure (10) is arranged between the gate region (26) and the source region (24) or between the gate region (26) and the drain region (28).

14. The method for producing a radiation detector (100) according to Claim 13, wherein the antenna structure is formed with a 2-armed or 4-armed structure.

15. The method for producing a radiation detector (100) according to Claim 13 or 14, wherein the capacitor (40) and the antenna structure (10) are tuned to one another in their resonant frequencies to form a common HF environment for receiving electromagnetic waves in the THz range.

## Revendications

1. Détecteur de rayonnement (100) comprenant :
a) une structure d'antenne (10) ; et
b) une structure de transistor à effet de champ FET (20) avec une zone de source (24), une zone de grille (26) et une zone de drain (28),
c) dans lequel ces zones (24, 26, 28) sont disposées sur un substrat (70) et forment des structures d'électrode (34, 36, 38) électriquement conductrices, indépendantes les unes des autres par métallisation ;
**caractérisé en ce que**
d) la structure d'électrode de la grille (36) entoure complètement la structure d'électrode de la source (34) ou la structure d'électrode du drain (38) dans un premier plan (E1) ;
e) la structure d'électrode entourée (34, 38) s'étend jusqu'au-dessus de la structure d'électrode de la grille (36) et y recouvre l'entourage au moins par endroits en surface dans un second plan (E2) au-dessus du premier plan (E1) ;
f) dans lequel une zone électriquement isolante (42) est disposée entre les zones de la structure d'électrode de la grille (36) recouvertes par la structure d'électrode entourée (34, 38) pour constituer un condensateur (40) avec une structure métal-isolateur-métal MIM.

2. Détecteur de rayonnement (100) selon la revendication 1, dans lequel la structure d'antenne (10) reposant sur le substrat (70) est constituée directement par les structures d'électrode (34, 36, 38).

3. Détecteur de rayonnement (100) selon l'une quelconque des revendications précédentes, dans lequel la structure d'électrode de la grille (36) dans le premier plan (E1) et la structure d'électrode entourant (34, 38) dans le second plan (E2) se recouvrent sensiblement sous la forme d'éléments de surface rectangulaires.

4. Détecteur de rayonnement (100) selon l'une quelconques des revendications précédentes, dans lequel la structure FET (20) est constituée sur la base de silice ou d'un semiconducteur III-V.

5. Détecteur de rayonnement selon l'une quelconques des revendications précédentes, dans lequel la base (12) de la structure d'antenne (10) est disposée entre la zone de grille (26) et la zone de source (24) ou entre la zone de grille (26) et la zone de drain (28).

6. Détecteur de rayonnement (100) selon l'une quelconques des revendications précédentes, dans lequel la structure d'antenne (10) forme une antenne à fente, dans lequel la structure d'antenne (10) présente au moins une ouverture émettrice (14) à l'intérieur d'une surface métallique (16).

7. Détecteur de rayonnement (100) selon l'une quelconques des revendications précédentes, dans lequel des courants à haute fréquence HF avec des fréquences supérieures à 100 GHz sont court-circuités sur le bord extérieur (18) de la structure d'antenne (10).

8. Détecteur de rayonnement (100) selon l'une quelconque des revendications précédentes, dans lequel la structure d'antenne (10) réalise un court-circuit HF entre 2 des 3 zones (24, 26, 28) de la structure FET (20).

9. Détecteur de rayonnement (100) selon l'une quelconque des revendications précédentes, dans lequel la structure d'antenne (10) est constituée de 2 branches ou de 4 branches.

10. Détecteur de rayonnement (100) selon l'une quelconque des revendications précédentes, comprenant au moins deux structures FET (20) montées en parallèle sur un substrat commun (70).

11. Détecteur de rayonnement (100) selon l'une quelconque des revendications précédentes, dans lequel le condensateur (40) et la structure d'antenne (10) forment un environnement HF commun, ajusté de manière à accorder le détecteur de rayonnement (100) à la réception d'ondes électromagnétiques dans la plage THz.

12. Détecteur de rayonnement (100) selon l'une quelconque des revendications précédentes, comprenant en plus un convertisseur de fréquence, dans lequel le convertisseur de fréquence convertit le rayonnement reçu en un signal de détection de basse fréquence.

13. Procédé de production d'un détecteur de rayonnement (100), comprenant les étapes suivantes :
• la préparation d'une structure de transistor à effet de champ FET (20) disposée sur un substrat (70) avec une zone de source (24), une zone de grille (26) et une zone de drain (28) ;
• la métallisation de la zone de grille (26), de la zone de source (24) et de la zone de drain (38), dans lequel des structures d'électrode (34, 36, 38) électriquement conductrices, indépendantes les unes des autres sont constituées, dans lequel soit la structure d'électrode de la source (34) soit la structure d'électrode du drain (38) sont complètement entourées dans un premier plan (E1) par la structure d'électrode de la grille (36), dans lequel la structure d'électrode entourée (34, 38) s'étend jusqu'au-dessus de la structure d'électrode de la grille (36) et l'entourage est recouvert au moins par endroits en surface dans un second plan (E2) au-dessus du premier plan (E1) par la structure d'électrode entourée (34, 38), dans lequel une zone électriquement isolante (42) est disposée entre les zones de la structure d'électrode de la grille (36) recouvertes par la structure d'électrode entourée (34, 38) pour constituer un condensateur (40) avec une structure métal-isolateur-métal MIM ; et
• la formation d'une structure d'antenne (10) disposée sur le substrat (70), dans lequel la structure d'antenne (10) reposant sur le substrat (70) est constituée directement par les structures d'électrode (34, 36, 38), dans lequel une ouverture émettrice (14) est constituée à l'intérieur d'une surface métallique (16) de la structure d'antenne (10) et dans lequel la base (12) de la structure d'antenne (10) est disposée entre la zone de grille (26) et la zone de source (24) ou entre la zone de grille (26) et la zone de drain (28).

14. Procédé de production d'un détecteur de rayonnement (100) selon la revendication 13, dans lequel la structure d'antenne (10) est conçue de manière à former 2 branches ou 4 branches.

15. Procédé de production d'un détecteur de rayonnement (100) selon la revendication 13 ou 14, dans lequel le condensateur (40) et la structure d'antenne (10) sont mutuellement accordés à la réception d'ondes électromagnétiques dans la plage THz sur leurs fréquences de résonance pour former un environnement HF commun.
